# EUROPEAN PATENT SPECIFICATION

(11) **EP 0 590 502 B1**
(45) Date of publication and mention of the grant of the patent: **28.01.1998**
(21) Application number: 93115287.0
(22) Date of filing: 22.09.1993
(51) Int. Cl.: H02M 7/537, H02M 7/5387, H01L 23/34, H05K 7/20

(54) **Inverter apparatus for electric rolling stock**
Wechselrichter für ein elektrisches Betriebsmittel
Onduleur pour matériel électrique

(30) Priority: 02.10.1992 JP 265025/92
(43) Date of publication of application: 06.04.1994
(73) Proprietor: HITACHI, LTD., Chiyoda-ku, Tokyo 100 (JP)
(72) Inventor: Saito, Shuji, Katsuta-shi, Ibaraki-ken (JP); Tsuboi, Takashi, Katsuta-shi, Ibaraki-ken (JP); Horie, Akira, Katsuta-shi, Ibaraki-ken (JP); Ando, Takeshi, Katsuta-shi, Ibaraki-ken (JP); Toyota, Eiichi, Katsuta-shi, Ibaraki-ken (JP); Matsui, Takayuki, Matsudo-shi, Chiba-ken (JP); Takaku, Toshihiko, Katsuta-shi, Ibaraki-ken (JP); Nakata, Kiyoshi, Nishiibaraki-gun, Ibaraki-ken (JP); Nakamura, Kiyoshi, Katsuta-shi, Ibaraki-ken (JP)
(74) Representative: Strehl Schübel-Hopf Groening & Partner

(56) References cited:
- EP-A- 0 519 305
- DE-C- 2 812 699
- DE-U- 9 107 692
- SOVIET PATENTS ABSTRACTS, S-X section, week 8907, 1989, March 29 DERWENT PUBLICATIONS LTD., London; & SU-A-1415 274 (LERA)

## Description

### BACKGROUND OF THE INVENTION

### 1. Field of the Invention

The present invention relates to an inverter apparatus for electric rolling stock and, in particular, to an inverter apparatus suitable for electric rolling stock, such as electric railcars and electric locomotives.

### 2. Description of the Related Art

A drive system for driving an induction motor at variable speeds by utilizing an inverter apparatus has been in practical use as a power system for driving electric rolling stock.

When applied, for example, to an electric railcar in which electric motors are distributed among a plurality of axels, such inverter apparatuses have to be mounted in a limited underfloor space, so that they are required to be as small as possible. Similarly, in electric locomotives, there is a demand for a reduction in the size of each inverter apparatus in order to increase the total capacity of the inverter apparatuses that can be mounted in a single locomotive.

Conventionally, GTO thyristors (gate turn-off thyristors) have been used as the semiconductor switch devices in inverter main circuits for driving electric rolling stock, as described in Japanese Utility Model Laid-Open No. 2-75738, or "GTO-Stromrichter fuer Bahnen" (SIEMENS, Sonderdruck aus ZEV-Glasers Annalen 113 (1989) Nr. 6/7 juni/juli, pages 259 to 272). This is due to the fact that the GTO thyristor provides a voltage and current capacity which are relatively large as compared with those of other types of semiconductor switch devices, such as BT (bipolar transistors) or IGBT (insulated-gate bipolar transistors). Therefore, the GTO thyristor enables the inverter main circuit section to be reduced in size.

To reduce the higher harmonies component of an output waveform, a so-called 3-level inverter (also called "a neutral clamping inverter"), which converts a 3-level DC current to an AC output through switching, has been proposed. In this 3-level inverter, an inverter main circuit, which corresponds to one inverter phase, comprises: a pair of DC input terminals connected to a DC power source; a neutral point terminal connected to the neutral point of the DC power source; a series connection circuit of first through fourth semiconductor switch devices connected between a pair of series input terminals; clamp diodes respectively connected between the node of the first and second semiconductor switch devices and the neutral point terminal and between the node of the third and fourth semiconductor switch devices and the neutral point terminal; and an AC output terminal connected to the node of the second and third semiconductor switch devices.

The GTO thyristor involves a large switching loss. In view of this, as described in the above-mentioned official gazette and document mentioned above, to an enhancement in cooling efficiency thereof, the GTO thyristor is formed as a disc, both sides of which constitute main electrodes, and conductive cooling blocks in which an effervescent refrigerant is sealed are pressed against these main electrodes. To secure the insulation between the cooling blocks on either side of the GTO thyristor and between the condensed portion of the refrigerant and the GTO thyristor, an insulating refrigerant is used. Flon, which provides an excellent cooling performance and insulating property, has generally been used as a refrigerant satisfying the above requirement.

The above prior-art technique, however, has the following problem: because of its large device switching loss, the large capacitance of the snubber capacitor and the snubber resistor for restraining the voltage rise upon turning off, etc., the GTO thyristor cannot have its switching frequency raised. In conventional GTOs for practical use, the switching frequency is approximately 500 Hz. Thus, when an inverter is formed by using GTO thyristors, there is a limit to the reduction in the harmonics distortion of the output waveform, resulting in a large ripple in the motor current, which leads to a large electromagnetic noise in the motor.

In view of this, semiconductor switch devices which can be driven by high-frequency pulse gate signals (hereinafter generally referred to as "high-frequency semiconductor switch devices"), such as bipolar transistors which permit an increase in switching frequency, IGBTs (insulated-gate bipolar transistors), MOS-gate-controlled thyristors, etc. might be used.

However, devices which are being used as such high-frequency semiconductor switch devices provide a generally low withstand voltage level (e.g., at a level of 1200v in general-purpose IGBTs), so that they cannot be applied as they are to electric rolling stock to be operated under a trolley voltage of DC 1500v. Further, generally speaking, high-frequency semiconductor switches in practical use have a relatively small current capacity, so that when they are applied to a large capacity inverter apparatus (which is used, for example, to drive an electric motor having a single-unit capacity of 200 kW or more), a plurality of such semiconductor devices connected in parallel have to be used.

Thus, in the case where high-frequency semiconductor switch devices like IGBTs are applied to an inverter apparatus for electric rolling stock, the size of the inverter main circuit section tends to be rather large, so that some contrivance in construction is required so as to reduce the size of the entire apparatus.

Further, from the viewpoint of flon pollution control, adoption of an alternate cooling system of a flon boiling/cooling type is required.

From DE-U-9 107 692 an inverter apparatus including the features of the first part of claim 1 is known.

### SUMMARY OF THE INVENTION

It is an object of the present invention to provide an inverter apparatus for electric rolling stock which uses semiconductor switch devices capable of being driven at a higher frequency than GTO thyristors and which can be made generally small.

This object is met by an inverter apparatus according to claim 1.

Preferred embodiments are disclosed in the depending claims.

In accordance with the present invention, an inverter apparatus for electric rolling stock in which a main circuit of each phase constituting an inverter comprises: a pair of DC input terminals connected to a DC power source; a neutral point terminal connected to a neutral point of the DC power source; a series connection circuit of first through fourth semiconductor switch modules connected between the pair of DC input terminals; clamp diodes respectively connected between a node of the first and second semiconductor switch modules and the neutral point terminal and between a node of the third and fourth semiconductor switch modules and the neutral point terminal; and an AC output terminal connected to a node of the second and third semiconductor switch modules, wherein the first through fourth semiconductor switch modules consist of semiconductor switch devices whereby each is capable of being driven at a higher frequency than a GTO thyristor and is provided on a heat conducting substrate through the intermediation of an insulating member, the first through fourth semiconductor switch modules are grouped into two pairs such that a pair of one type consists of a combination of one of the first and fourth semiconductor switch modules and one of the second and third semiconductor switch modules and that a pair of the other type consists of the remaining one of the first and fourth semiconductor switch modules and the remaining one of the second and third semiconductor switch modules and are attached to heat receiving plates in such a way that each pair of semiconductor switch modules is attached to a separately or commonly heat receiving plate, and the semiconductor switch modules have cooling means, connected for heat transport to the heat receiving plate, for cooling the heat receiving plate.

Here, the semiconductor switch devices may consist of one of the following types: bipolar transistors, insulated-gate bipolar transistors, and MOS-gate-controlled thyristors.

The attachment of the two pairs of semiconductor switch modules to the heat receiving plates may be effected in such a way that different pairs are attached to different heat receiving plates, or all of them may be attached to one and the same heat receiving plate. It is also possible to form different heat receiving plates for different inverter phases, or to form a heat receiving plate common to the inverter phases.

It is desirable for the heat receiving plates to be detachably mounted in an opening in a vertical outer wall of a housing hermetically containing the inverter components, in such a way that the surface on which the semiconductor switch modules are mounted is located on the inner side. Here, it is desirable that the semiconductor switch modules attached to the heat receiving plates should be arranged in the order of their series connection.

To attain a reduction in size, the cooling means is preferably formed by mounting a heat radiating fin to a part of a heat transfer member, which is integrally attached to each heat receiving plate. A heat transfer pipe is preferably adopted as the heat transfer member. A part of the heat pipe is embedded in each heat receiving plate, and the heat radiating fin is attached to an exposed section of the hat pipe to form the cooling means. It is also possible to attach the heat radiating fin directly to the surface of each heat receiving plate which is opposite to that surface thereof to which the semiconductor switch modules are attached. In that case, the heat radiating fin and the heat receiving plate can be formed as an integral unit.

Due to the above-described construction, it is possible, in accordance with this invention, to achieve the above-mentioned objects by virtue of the following effects :

In the present invention, it is possible to achieve a reduction in higher harmonics since it basically uses a 3-level inverter circuit. Further, due to the use of semiconductor switch devices which can be used at a higher frequency than GTO thyristors, it is possible to reduce the ripple of the higher harmonics and the output current by increasing the switching frequency, thereby attaining a further reduction in electromagnetic noise. When, for example, IGBTs are used as the high-frequency semiconductor switch devices, it is desirable for the switching frequency to be selected within the range of 500 to 3 kHz. When bipolar transistors are used, the switching frequency may be 1 kHz or more.

The loss (calorific value) of the first through fourth semiconductor switch devices, which form the 3-level inverter main circuit, varies in relation to the operation modes (power running, coasting, and braking) of the associated electric rolling stock motor. It has been found that the loss of the first and fourth semiconductor switch devices has a peak during power running, and the loss of the second and third semiconductor switch devices has a peak during braking. Thus, by attaching a combination of the first and second semiconductor switch modules, or a combination of the third and fourth semiconductor switch modules, each combination exhibiting a discrepancy in loss peak, to a common heat receiving plate and attaching a cooler to that heat receiving plate, it is possible to level the heat load of the cooler in terms of time. Accordingly, the size of the cooler can be reduced, thereby contributing to a reduction in the size of the entire apparatus.

Further, by attaching clamping diodes to the same heat receiving plate as the semiconductor switch modules, the heat generating semiconductor devices and the cooling system thereof can be made more compact, thereby contributing to a reduction in the size of the entire apparatus.

The semiconductor switch devices constituting the semiconductor switch modules, and the free-wheeling diodes, are arranged on a substrate through the intermediation of an insulating member. Thus, due to the presence of the insulating member, the insulation to the ground for the semiconductor switch devices, etc. is secured within the modules. Therefore, the heat receiving plates, to which the semiconductor switch modules, are attached can be grounded, and there no need to specially provide insulation to the ground for the heat receiving plates and the coolers thermally connected thereto, so that the cooling system configuration can be simplified, thereby contributing to a reduction in the size of the entire apparatus.

Further, since the heat receiving plates can be grounded, a heat pipe of a simple construction using water as the refrigerant can be used as the heat transfer member for thermally connecting each heat receiving plate and the cooler with each other, thereby securing the requisite cooling performance and avoiding use of flon, which is a harmful substance.

In addition, since the heat receiving plates can be grounded, the inverter components can be directly attached to a housing for containing them hermetically. Thus, when the heat receiving plates are detachably mounted in an opening formed in the outer wall of this housing, the heat receiving plates are exposed on the outer side of the housing. As a result, the exposed surfaces of the heat receiving plates also effectively function as radiation surfaces, so that, the temperature rise inside the housing can be restrained as compared with the conventional structure in which the heat receiving plates are provided inside the housing. Moreover, a reduction in size can be attained by reducing the heat radiation capacity of the cooler.

### BRIEF DESCRIPTION OF THE DRAWINGS

Fig. 1 shows the construction of the essential part of an inverter apparatus for electric rolling stock according to an embodiment of the present invention;
Fig. 2 is a view taken in the direction of arrows II-II of the embodiment of Fig. 1;
Fig. 3(A) is an enlarged view showing an arrangement of semiconductor switch modules and clamp diodes on heat receiving plates;
Fig. 3(B) shows the electrical connection between the semiconductor switch modules and the clamp diodes;
Fig. 4 is a partially cutaway perspective view showing the construction of a semiconductor switch module according to an embodiment of the present invention;
Fig. 5 shows the power system configuration of an inverter apparatus for electric railcars;
Fig. 6 is a circuit diagram showing the construction of a main circuit corresponding to one phase of a 3-level inverter according to the present invention;
Fig. 7 is a chart illustrating losses in the semiconductor switch modules and the clamp diodes in relation to the operation modes of the inverter;
Fig. 8 is a circuit diagram showing an inverter main circuit to illustrate patterns of heat receiving plate arrangement; and
Fig. 9 shows a cooler according to another embodiment of the present invention.

### DETAILED DESCRIPTION OF THE PREFERRED EMBODIMENTS

The present invention will now be described with reference to embodiments shown in the drawings.

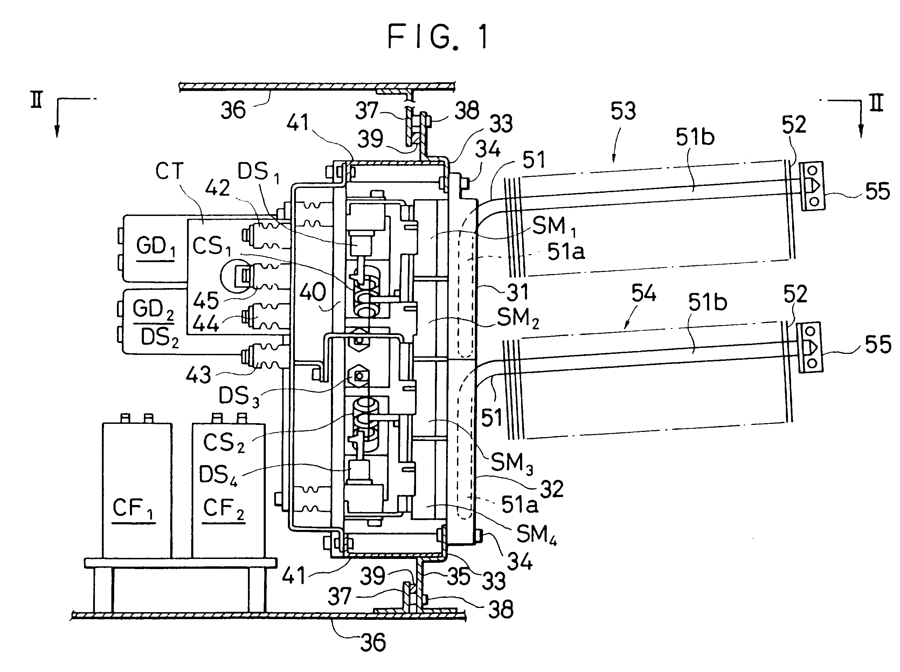

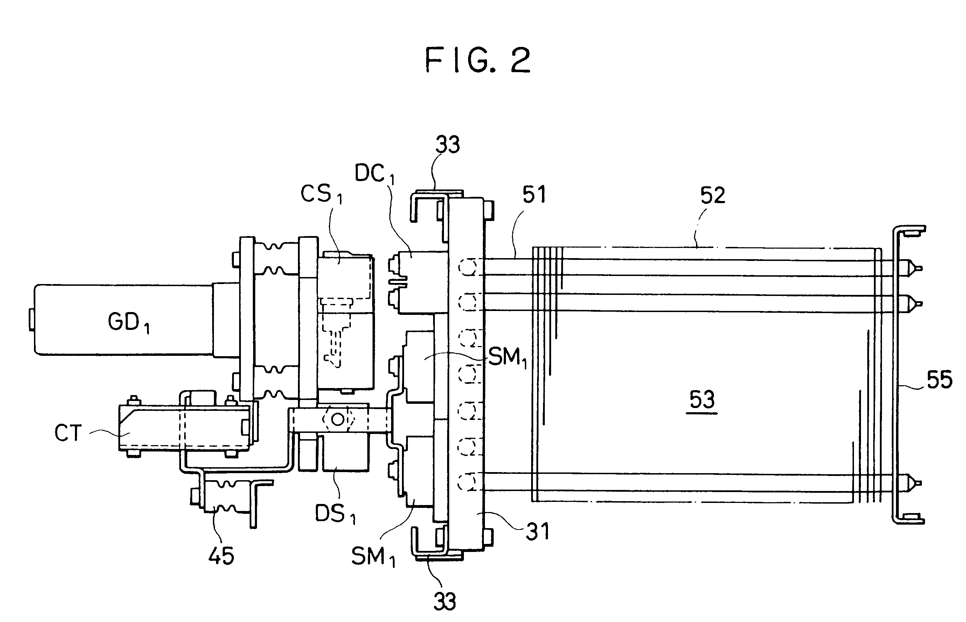

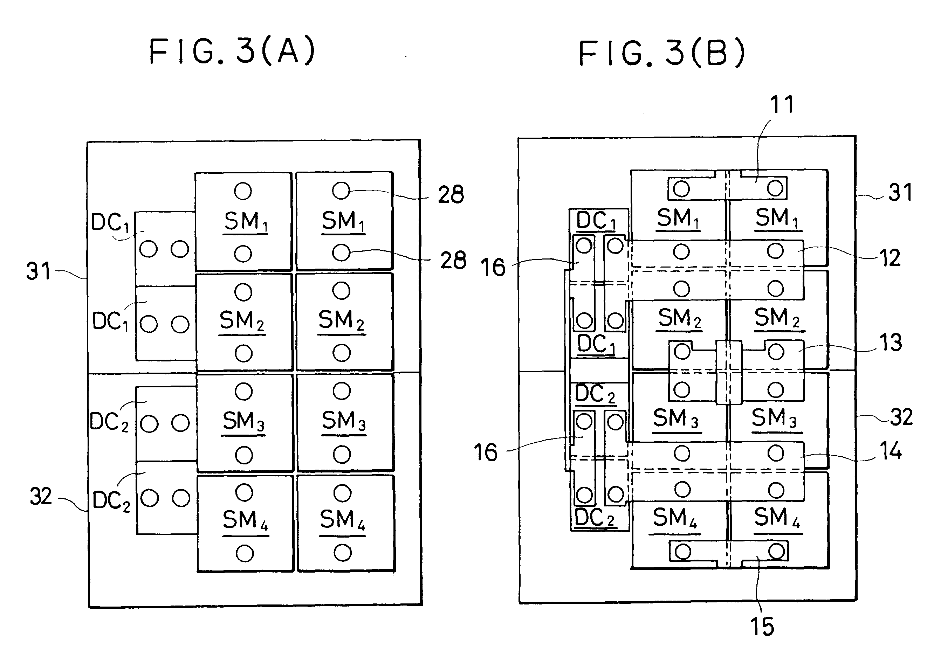

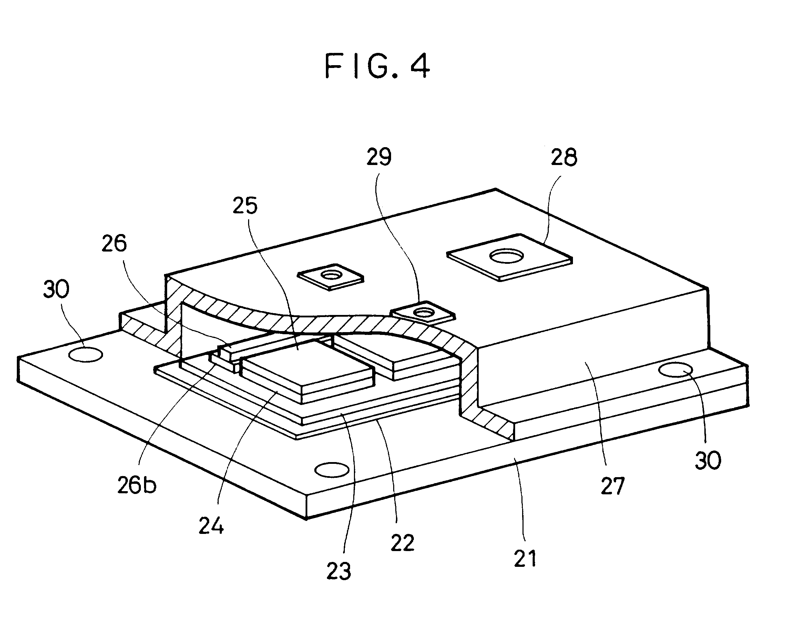

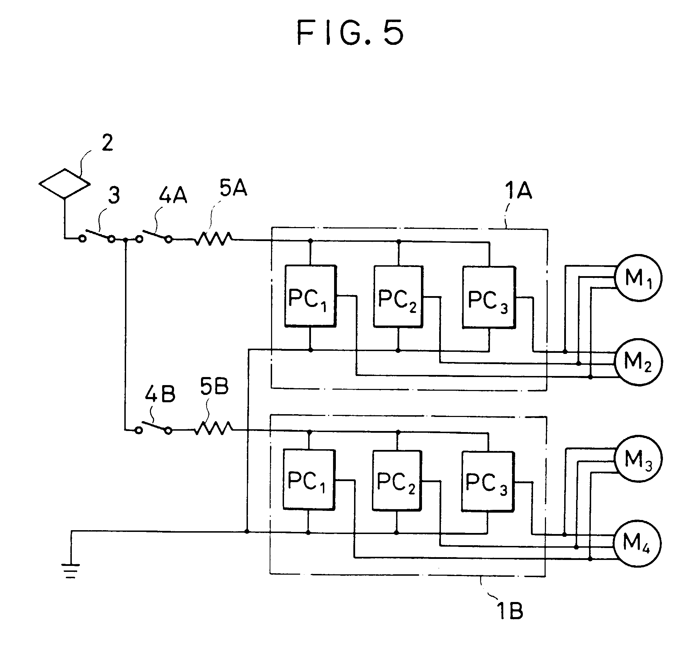

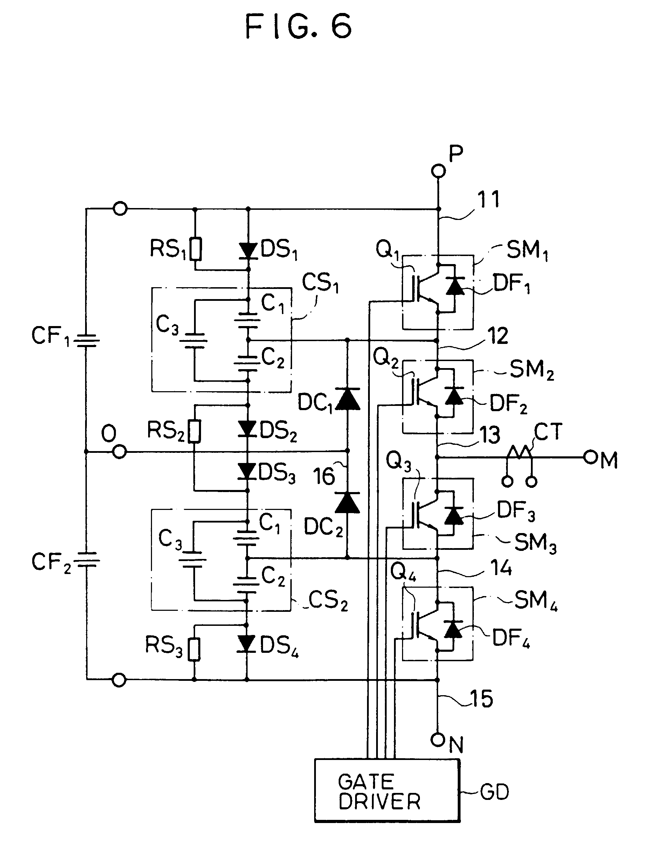

An inverter apparatus according an embodiment of the present invention will be described with reference to Figs. 1 through 7. Fig. 1 shows the construction of the essential part of an inverter apparatus for electric railcars according to an embodiment of the present invention; Fig. 2 is a view taken in the direction of arrows II-II of Fig. 1; Fig. 3(A) is an enlarged view showing an arrangement of semiconductor switch modules and clamp diodes on heat receiving plates; Fig. 3(B) shows the electrical connection between the semiconductor switch modules and the clamp diodes; Fig. 4 is a partially cutaway perspective view showing the construction of a semiconductor switch module according to this embodiment; Fig. 5 shows the overall power system configuration of an inverter apparatus for electric railcars according to this embodiment; and Fig. 6 is a circuit diagram showing the construction of an inverter main circuit corresponding to one inverter phase.

First, the overall construction of an inverter apparatus according to this embodiment and an inverter main circuit therein will be described with reference to Figs. 5 and 6.

As shown in Fig. 5, the driving system of an electric railcar to which the inverter apparatus of this embodiment is applied consists of four induction motors M₁, M₂, M₃ and M₄, for which two inverter apparatuses 1A and 1B having the same construction are provided, the induction motors M₁ and M₂ being driven by the inverter apparatus 1A and the induction motors M₃ and M₄ by the inverter apparatus 1B. Each of the inverter apparatuses 1A and 1B includes power units PU₁ through PU₃ obtained by dividing a 3-phase inverter main circuit in terms of phase. One DC input terminal of each of the power units PU₁ through PU₃ is connected through a breaker 3, open switches 4A and 4B and filter reactors 5A and 5B to a pantagraph 2, the other DC input terminal thereof being grounded.

As shown in Fig. 6, a so-called 3-level inverter circuit is used as the main circuit of each of the power units PU₁ through PU₃. Fig. 6 shows a main circuit corresponding to one inverter phase and having a pair of DC input terminals P and N, of which terminal P is connected to a DC line connected to the pantagraph 2 of Fig. 3, terminal N being grounded. Connected to the pair of DC input terminals P and N is a series circuit of two filter capacitors CF₁ and CF₂, the node of which constitutes the neutral point of the DC power source and is connected to a neutral point terminal O. Connected between the pair of DC input terminals P and N is a series circuit of four semiconductor switch modules SM₁ through SM₄, which are formed by anti-parallel connection of IGBTs Q₁ through Q₄ and free-wheeling diodes DF₁ through DF₄. The node of semiconductor switch modules SM₁ and SM₂ and that of the semiconductor switch modules SM₃ and SM₄ are connected to the neutral point terminal O through clamp diodes DC₁ and DC₂, respectively. The node of the semiconductor switch modules SM₂ and SM₃ is connected to an AC output terminal M.

A snubber circuit is composed of snubber capacitors CS₁ and CS₂, snubber diodes DS₁ through DS₄, and snubber resistors RS₁ through RS₃. Each of the snubber capacitors CS₁ and CS₂ is composed of three capacitors C₁ through C₃ in delta connection. Gate pulses amplified by a gate driver GD are supplied to the gates of the semiconductor switch modules SM₁ through SM₄.

Here, the construction of the power units PU will be described with reference to Figs. 1 through 4. Fig. 1 is a schematic side view of the essential part of a power unit. Fig. 2 is a view taken in the direction of arrows II-II of Fig. 1. Figs. 3(A) and 3(B) are enlarged views showing an arrangement of semiconductor switch modules and clamp diodes on heat receiving plates and electrical connection therebetween.

As shown in these drawings, each of the semiconductor switch modules SM₁ through SM₄ is composed of two semiconductor switch modules arranged side by side and connected in parallel. The semiconductor switch modules SM₁ and SM₂ on the positive side are arranged vertically (as seen in the drawing) on the surface of a first heat receiving plate 31 and attached thereto, and the semiconductor switch modules SM₃ and SM₄ on the negative side are arranged vertically (as seen in the drawing) on the surface of a second heat receiving plate 32 and attached thereto. Further, the clamp diodes DC₁ and DC₂ are attached to the surfaces of the heat receiving plates 31 and 32, respectively. Each of the clamp diodes DC₁ and DC₂ also consists of two diodes connected in parallel. As shown in Fig. 3(B), the semiconductor switch modules SM₁ through SM₄ and the clamp diodes DC₁ and DC₂ are connected by conductors 11 through 16 in accordance with the circuit configuration of Fig. 6.

The semiconductor switch modules SM₁ through SM₄ are of the same construction, each having a structure as shown in the partially cutaway perspective view of Fig. 4. As shown in the drawing, each semiconductor switch module is formed as follows: an insulating plate 22 made of alumina or the like is provided on a substrate 21 made of a material having good heat transfer property, such as copper. A first main electrode 23 formed of a conductive material, such as a copper plate, is provided on the insulating plate 22. A plurality of thermal stress mitigating plates 24 made of a conductive material, such as molybdenum, are provided on the main electrode 23. An IGBT device 25 is provided on each of the thermal stress mitigating plates 24. Further, a second main electrode 26a formed of a conductive material like a copper plate is provided on the first main electrode 23 through the intermediation of an insulating plate 26b. All the above components are covered with an insulating case 27. A pair of main electrode terminals 28 and gate terminals 29 are exposed on the outer surface of the insulating case 27. Further, free-wheeling diodes DF (not shown) which are in anti-parallel connection with the IGBT devices 25 are provided on the first main electrode 23. The semiconductor switch module, described above, is attached to the first or second heat receiving plate 31 or 32 by means of bolt holes 30 provided in the substrate 21.

The first and second heat receiving plates 31 and 32 are formed of a material excelling in heat transfer property, such as aluminum. The heat receiving plates 31 and 32 are fastened to a power unit support frame 33, which is formed as a rectangular frame, by means of bolts 34.

A flange 35 is provided in the periphery of the power unit support frame 33. A housing 36, which is only partly shown in Fig. 1, contains the inverter components. A frame-like mounting seat 37 is formed in the periphery of a side opening of the housing 36. The flange 35 of the power unit support frame 33 is fastened to the mounting seat 37 through the intermediation of a packing 39, thereby attaching the power unit support frame 33 to the housing 36. Thus, the heat receiving plates 31 and 32 and the power unit support frame 33 constitute a part of a side surface of the housing 36, with the packing 39 ensuring the requisite airtightness.

A part mounting member 40 is provided on the opposite side of the heat receiving plates 31 and 32 with respect to the semiconductor switch modules SM₁ through SM₄. The part mounting member 40 is secured to the power unit support member 33 by means of arms 41. The snubber capacitors CS₁ and CS₂ and the snubber diodes DS₁ through DS₄ are mounted on the part mounting member 40 in such a way as to be opposed to the semiconductor switch modules SM₁ through SM₄, thereby realizing a snubber circuit with the shortest wiring length.

Terminal blocks 42 through 45 formed of an insulating material like epoxy resin are attached to the other side of the part mounting member 40. The DC input terminals P and N, the neutral point terminal O, and the AC output terminal M are supported by the terminal blocks 42 through 45. Further, a current transformer CT and gate drivers GD (GD₁ and GD₂) are arranged by the side of the terminal blocks 42 through 45 and attached to the part mounting member 40. The filter capacitors CF₁ and CF₂ are arranged in the space below the current transformer CT and the gate drivers GD. The gate drivers GD₁ and GD₂ respectively correspond to the positive and negative sides of the semiconductor switch modules.

Coolers 53 and 54, each consisting of a plurality of heat pipes 51 and heat radiating fins 52 attached thereto, are thermally attached to the heat receiving plates 31 and 32, respectively. The heat pipes 51, into which water serving as effervescent refrigerant is introduced, is formed of a material excelling in heat transfer property and workability, such as copper. To facilitate boiling at a low temperature, or to prevent non-condensable gases from being mixed in the refrigerant, the heat pipes are adjusted to negative pressure.

In this embodiment, each heat pipe 51 is bent into an L-shape, one straight pipe section being embedded in the heat receiving plate 31, 32 and thermally connected thereto to form an evaporating section 51a which supports the heat pipe on the heat receiving plate. To the other straight pipe section, which is slightly inclined upwards with respect to the horizontal plane, a plurality of radiating fins 52 are attached to form a condensing section 51b.

Next, the operation of the above-described inverter apparatus for electric railcars will be described laying stress on the features of the present invention.

The gate pulses for driving the inverter apparatus for electric railcars of this embodiment described above are generated in a PWM controller (not shown) in accordance with the well-known basic operation of a 3-level inverter (see "A New Neutral-Point-Clamped PWM Inverter, IEEE Transactions on Industry Applications", vol. 1A-17, No. 5, September/October 1981). In the basic operation of a 3-level inverter, the semiconductor modules SM₁ through SM₄ are turned ON and OFF in accordance with the following three conduction modes, selectively supplying a 3-level voltage to the AC output terminal M. In the following table, Ed indicates the total DC voltage, and it is assumed here that the neutral point voltage is 0v.

| | SM₁ | SM₂ | SM₃ | SM₄ | Output voltage |
|---|---|---|---|---|---|
| First Conducting Mode | ON | ON | OFF | OFF | Ed/2 |
| Second Conducting Mode | OFF | ON | ON | OFF | 0 |
| Third Conducting Mode | OFF | OFF | ON | ON | -Ed/2 |

With such a 3-level inverter, the number of voltage levels of the output voltage pulses increases as compared with that of an ordinary 2-level inverter, so that the apparent switching frequency is augmented, resulting in a reduction in higher harmonics. Further, due to the use of IGBTs as the semiconductor switch devices, the switching frequency can be increased to the range : 500 Hz to 3 kHz. This also helps to restrain higher harmonics, thereby reducing the electromagnetic noise.

The PWM controller generates gate pulses in accordance with the above three conduction modes and the specified target speed and travelling modes of the associated electric railcar to turn ON and OFF the semiconductor switch modules through the gate drivers, thereby effecting variable control on the output voltage and frequency of the inverter apparatus and controlling the inverter apparatus in accordance with the travelling modes (power running, coasting and braking) of the electric railcar.

The semiconductor switch modules SM₁ through SM₄ generate heat as a result of the loss during the ON operation. In this embodiment, the heat is dissipated by the cooling system consisting of the heat receiving plates 31 and 32 and the coolers 53 and 54. That is, the heat of the semiconductor switch modules SM₁ through SM₄ is first transferred through the substrates 21 to the heat receiving plates 31 and 32, causing the temperature of these plates to rise. Then, as a result of the temperature rise in the heat receiving plates 31 and 32, the water in the evaporating sections 51a of the heat pipes 50 boils to evaporate, and the resulting heat of evaporation cools the heat receiving plates 31 and 32. The vaporized water in the heat pipes 51 is led to the condensing sections 51b and subjected to heat exchange through the heat radiating fins with the running wind (which is basically in a direction perpendicular to the plane of the drawing) of the electric railcar, and is thereby condensed. The condensed water is conveyed on the inner walls of the heat pipes 51 and fed back to the evaporating sections 51a to repeat the cooling operation described above.

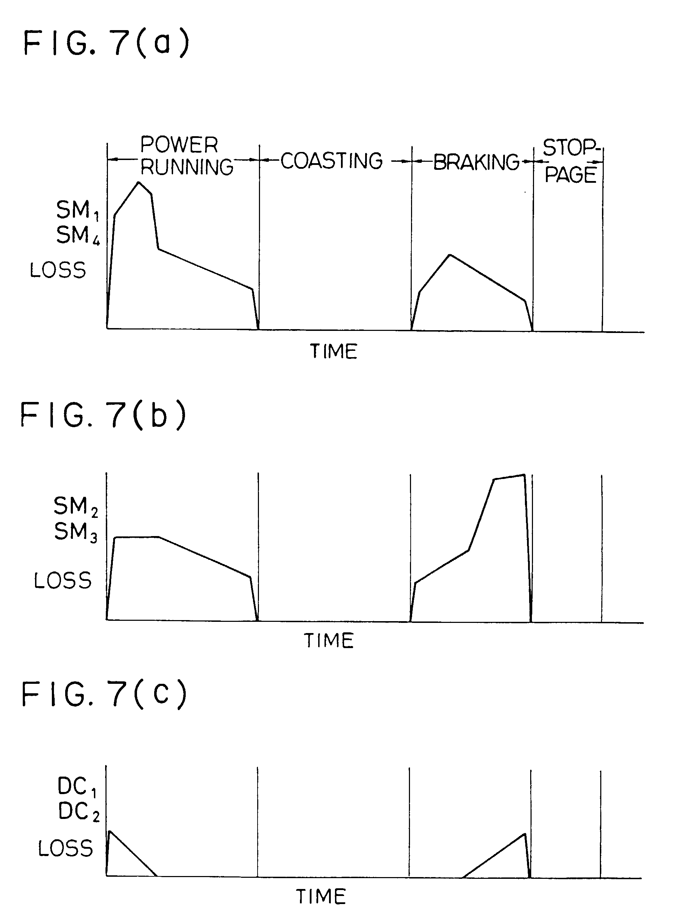

It has been found that the loss (heat generation amount) of the semiconductor switch modules SM₁ through SM₄ is related to the travelling modes (power running, coasting, and braking) of the associated electric railcar, as indicated by the semiconductor device heat generation cycles shown in Figs. 7(a) and 7(b). The loss of the semiconductor switch modules SM₁ and SM₄ has a peak during power running, whereas the loss of the semiconductor switch modules SM₂ and SM₃ has a peak during braking.

In view of this, the present embodiment adopts an arrangement in which, as shown in Fig. 1, a pair composed of the semiconductor switch modules SM₁ and SM₂, having a disparity in loss peak, is attached to the same heat receiving plate 31, and, similarly, a pair composed of the semiconductor switch modules SM₃ and SM₄ is attached to the same heat receiving plate 32. Due to this arrangement, the amount of heat transferred to the heat receiving plates during power running and the amount of heat transferred thereto during braking are equalized, whereby the heat loads on the coolers 53 and 54 are leveled to a larger degree as compared with the case where the coolers are individually provided with respect to the semiconductor switch modules SM₁ through SM₄. Thus, with this embodiment, it is possible to reduce the size of the coolers.

Further, in the semiconductor module M, the free-wheeling diodes DF are provided on the same substrate as the IGBTs so as to make the heat-generating semiconductor devices and the cooling system thereof more compact, thereby contributing to a reduction in the size of the entire apparatus.

Similarly, since the clamp diodes DC₁ and DC₂ are attached to the same heat receiving plates 31 and 32 as the semiconductor switch modules SM, the heat-generating semiconductor devices and the cooling system thereof can be made still more compact, thereby contributing to a reduction in the size of the entire apparatus. Further, the loss of the clamp diodes DC₁ and DC₂ varies in relation to the traveling modes of the electric railcar, as shown in Fig. 7(c), so that the heat load on the coolers can be leveled to some degree as compared with the case in which the coolers are individually provided.

As shown in Fig. 4, since the IGBTs and the free-wheeling diodes, constituting the semiconductor switch modules SM, are provided on the substrate 21 through the intermediation of the insulating plate 22 so as to ensure the insulation to the ground within the module, it is possible to set the heat receiving plates 31 and 32 to the ground potential. This eliminates the need for the insulation to the ground for the heat receiving plates 31 and 32 and the coolers 53 and 54, which helps to simplify the construction of the cooling system and contributes to a reduction in the size of the entire apparatus. Further, this arrangement makes it possible to employ heat pipes using a non-insulating refrigerant like water as the heat transfer members for thermally connecting the heat receiving plates 31 and 32 with the coolers 53 and 54. Thus, a cooling system which does not use the harmful flon can be realized without involving a deterioration in cooling performance.

Further, due to the arrangement in which the heat receiving plates can be set to the ground potential, the heat receiving plates 31 and 32 are detachably mounted in an opening in the vertical outer wall of the housing 36, with the semiconductor switch modules SM being located on the inner side, so that one surface of each of heat receiving plates 31 and 32 is exposed to on the outer side of the housing 36. As a result, the exposed surfaces of the heat receiving plates also function as radiating surfaces, so that the temperature rise inside the housing can be suppressed and, at the same time, the radiation capacity of the coolers can be reduced so as to attain a reduction in their size.

The present invention is not restricted to the above-described embodiment. It can be modified as follows :

For example, the high-frequency semiconductor switch devices are not limited to IGBTs. The same effect can be obtained by using other semiconductor switch devices which can be driven at higher frequency than GTO, such as bipolar transistors or MOS-gate-controlled thyristors.

While the present invention has been described with reference to an example having separate heat receiving plates 31 and 32 equipped with coolers 53 and 54, respectively, the same effect can be obtained by forming the heat receiving plates 31 and 32 as a single plate. However, taking into account the fact that the assembly work is performed after mounting the coolers to the heat receiving plates, the structure having two separate plates is more convenient since it enables the components to be handled more easily during the assembly.

It is also possible to adopt a double-layered structure in which the heat receiving plates 31 and 32 are divided between the semiconductor switch module side and the cooler side. This further facilitates the fabrication and assembly of the apparatus. However, such a structure involves a possibility that the cooling effect will deteriorate due to the resistance of heat transfer between the heat receiving plates of the two layers.

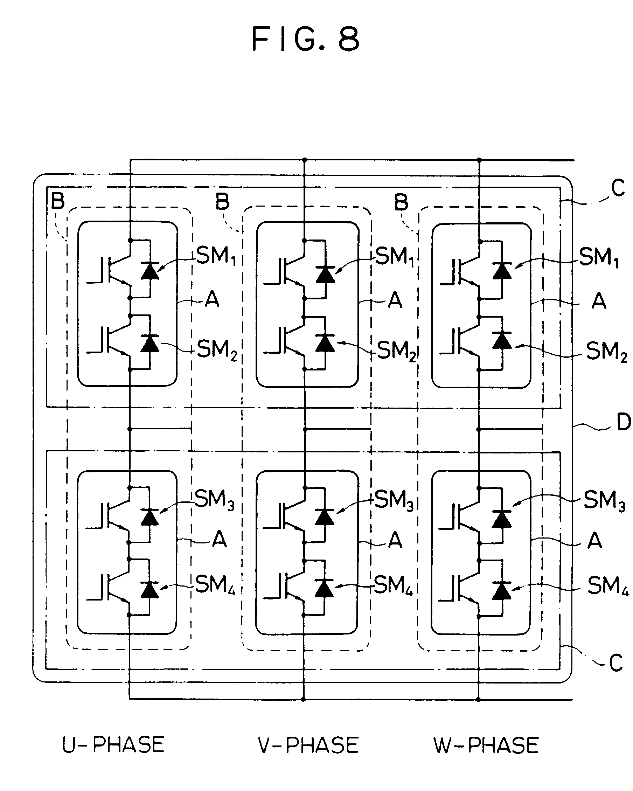

Regarding the division of the heat receiving plates, several patterns as shown in Fig. 8 are applicable. The drawing schematically shows a main circuit section of a three-phase inverter in order to illustrate heat-receiving-plate dividing patterns A through D. Dividing pattern A, shown in Fig. 8, corresponds to the above-described embodiment. In this pattern, a heat receiving plate having semiconductor switch modules SM₁ and SM₂ and one having semiconductor switch modules SM₃ and SM₄ are provided for each of the three phases: U, V and W, those heat receiving plates having semiconductor switch modules SM₁ and SM₂ being arranged on the positive-side arm and those having semiconductor switch modules SM₃ and SM₄ on the negative-side arm. In pattern B, a heat receiving plate having semiconductor switch modules SM₁, SM₂, SM₃ and SM₄ are provided for each of the three phases: U, V and W, the heat receiving plates being attached to the positive-side and the negative-side arms which are common to these heat receiving plates. In pattern C, the heat receiving plates are grouped into those on the positive-side arm (SM₁ and SM₂) and those on the negative-side arm (SM₃ and SM₄), the two arms being common to the U, V and W-phases. In pattern D, the heat receiving plate is common to the 3-phase positive-side (SM₁ and SM₂) and negative-side (SM₃ and SM₄) arms. In all of these dividing patterns, two semiconductor switch modules SM for each phase, differing in loss peak depending upon the operation mode (a combination of SM₁ and SM₂ or SM₃, or a combination of SM₄ and SM₂ or SM₃), are at least attached to a common heat receiving plate.

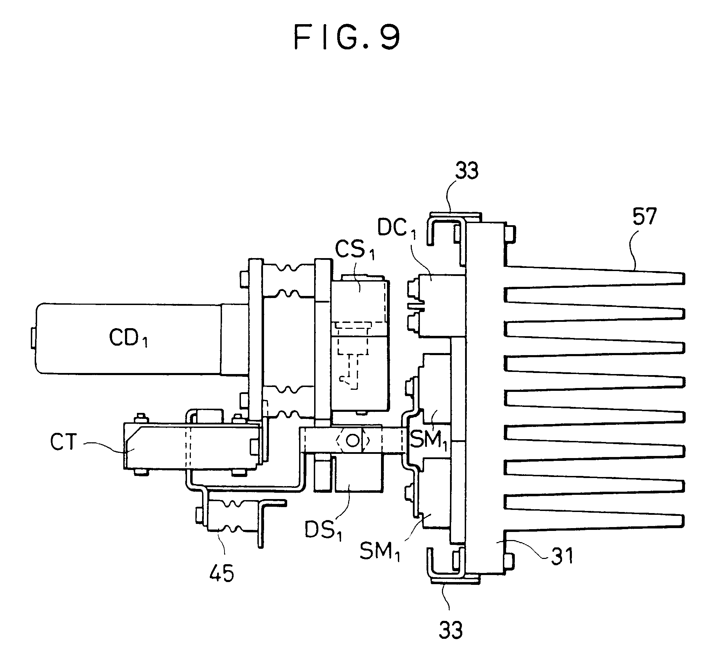

Instead of employing the coolers in the above embodiment, which use heat pipes, it is also possible, as shown in Fig. 9, to use heat radiating fins 57 integrally formed on or attached to the heat receiving plate 31 (or 32). When the heat receiving plate 31 is formed of aluminum, it is desirable for the heat radiating fins 57 to be integrally formed with the heat receiving plate 31 by extrusion or drawing. Further, though not shown, by providing a fan in such a way as to generate an air flow in a direction perpendicular to the plane of the drawing, it is possible to obtain an enhanced cooling performance.

## Claims

1. An inverter apparatus for electric rolling stock of the type in which an inverter main circuit of each phase constituting an inverter comprises: a pair of DC input terminals (P, N) connected to a DC power source; a neutral point terminal (O) connected to a neutral point of said DC power source; a series-connection circuit of first through fourth semiconductor switch modules (SM₁...SM₄) connected between said pair of DC input terminals; clamp diodes (DC₁, DC₂) connected between a node of said first and second semiconductor switch modules and said neutral point terminal and between a node of said third and fourth semiconductor switch modules and said neutral point terminal; an AC output terminal (M) connected to a node of said second and third semiconductor switch modules, and heat receiving means (31, 32, 53, 54) connected to said first through fourth semiconductor switch modules;
characterized in that
said first through fourth semiconductor switch modules (SM₁...SM₄) consist of semiconductor switch devices (Q₁...Q₄) each capable of being driven at a higher frequency than 500 Hz and being provided on a heat conducting substrate (21) through the intermediation of an insulating member (22),
said first through fourth semiconductor switch modules are grouped into two pairs such that one pair consists of a combination of one of said first and fourth semiconductor switch modules and one of said second and third semiconductor switch modules and that the other pair consists of the remaining one of said first and fourth semiconductor switch modules and the remaining one of said second and third semiconductor switch modules each pair of semiconductor switch modules is attached to the heat receiving means and
said heat receiving means comprises at least one heat receiving plate (31, 32) and cooling means (53, 54) connected to said heat receiving plate for cooling said heat receiving plate.

2. The apparatus of claim 1, wherein said semiconductor switch devices (Q₁ ...Q₄) are bipolar transistors, insulated-gate bipolar transistors, or MOS-gate-controlled thyristors.

3. The apparatus of claim 1 or 2, wherein said semiconductor switch modules are grouped into a pair (SM₁, SM₂) of said first and second semiconductor switch modules and a pair (SM₃, SM₄) of said third and fourth semiconductor switch modules for said inverter main circuit of each phase, and
heat receiving plates (31, 32) are separately provided for each of said pairs of semiconductor switch modules for said inverter main circuit of each phase.

4. The apparatus of claim 1 or 2, wherein heat receiving plates (31, 32) are attached commonly to said two pairs of semiconductor switch modules (SM₁, SM₂; SM₃, SM₄) and separately to said inverter main circuit of each phase.

5. The apparatus of claim 1 or 2, wherein said semiconductor switch modules are grouped into a pair (SM₁, SM₂) of said first and second semiconductor switch modules and a pair (SM₃, SM₄) of said third and fourth semiconductor switch modules for said inverter main circuit of each phase, and
heat receiving plates (31, 32) are common to said pairs of said semiconductor switch modules.

6. The apparatus of claim 1 or 2, wherein said semiconductor switch modules are grouped into a pair (SM₁, SM₂) of said first and second semiconductor switch modules and a pair (SM₃, SM₄) of said third and fourth semiconductor switch modules for said inverter main circuit of each phase, and
heat receiving plates (31, 32) are attached separately for each of said pairs and, at the same time, commonly to said inverter main circuit of each phase.

7. The apparatus of claim 1 or 2, wherein heat receiving plates (31, 32) are provided commonly to said two pairs and commonly to the inverter main circuit of each phase.

8. The apparatus of any one of claims 1 to 7, wherein said clamp diodes (DC₁, DC₂) are attached to heat receiving plates (31, 32).

9. The apparatus of any one of claims 1 to 8, wherein heat receiving plates (31, 32) are detachably mounted in an opening in an outer wall of a housing (36) hermetically containing the components of said inverter in such a way that the surfaces of said heat receiving plates having said semiconductor switch modules (SM₁...SM₄) are located on the inner side of said housing.

10. The apparatus of claim 9, wherein said first through fourth semiconductor switch modules (SM₁...SM₄) attached to said heat receiving plates (31, 32) are arranged in the order of their series connection.

11. The apparatus of any one of claims 1 to 10, wherein said cooling means (53, 54) consist of heat pipes (51) partly embedded in heat receiving plates (31, 32) and heat radiating fins (52) attached to exposed portions of said heat pipes.

12. The apparatus of any one of claims 1 to 10, wherein said cooling means consists of heat radiating fins (57) connected for heat transfer to heat receiving plates (31, 32) facing oppositely of the surface having said semiconductor switch modules (SM₁...SM₄).

13. The apparatus of claim 12, wherein said heat radiating fins (57) are integrally formed with said heat receiving plates (31, 32).

## Patentansprüche

1. Wechselrichter für elektrische Fahrzeuge des Typs, bei dem eine Wechselrichter-Hauptschaltung von jeder Phase, die einen Wechselrichter bildet:
ein Paar Gleichspannungs-Eingangsanschlüsse (P, N), die mit einer Gleichspannungsquelle verbunden sind; einen Nullpunkt-Anschluß (0), der mit einem Nullpunkt der Gleichspannungsquelle verbunden ist; eine Reihenschaltung aus ersten bis vierten Halbleiter-Schaltmodulen (SM₁...SM₄), die mit dem Paar Gleichspannungs-Eingangsanschlüsse verbunden sind; Klemmdioden (DC₁, DC₂), die zwischen einen Knotenpunkt des ersten und zweiten Halbleiter-Schaltmoduls und dem Nullpunkt-Anschluß und zwischen einen Knotenpunkt des dritten und vierten Halbleiter-Schaltmoduls und dem Nullpunkt-Anschluß geschaltet sind; einen Wechselspannungs-Ausgangsanschluß (M), der mit einen Knotenpunkt des zweiten und dritten Halbleiter-Schaltmoduls verbunden ist und eine wärmeaufnehmende Einrichtung (31, 32, 53, 54), die mit den ersten bis vierten Halbleiter-Schaltmodulen verbunden ist, aufweist;
dadurch **gekennzeichnet**, daß
die ersten bis vierten Halbleiter-Schaltmodule (SM₁... SM₄) aus Halbleiter-Schaltbauelementen (Q₁...Q₄) bestehen, die bei einer über 500 Hz liegenden Frequenz betrieben werden können und auf einem wärmeleitenden Substrat (21) mit einem dazwischen liegenden isolierenden Element (22) vorgesehen sind,
die ersten bis vierten Halbleiter-Schaltmodule so in zwei Paare aufgeteilt sind, daß das eine Paar aus einer Kombination des ersten oder vierten Halbleiter-Schaltmoduls und des zweiten oder dritten Halbleiter-Schaltmoduls besteht und das andere Paar aus dem verbleibenden ersten oder vierten Halbleiter-Schaltmodul und dem verbleibenden zweiten oder dritten Halbleiter-Schaltmodul besteht, wobei jedes Paar von Halbleiter-Schaltmodulen an der wärmeaufnehmenden Einrichtung angebracht ist, und
die wärmeaufnehmende Einrichtung wenigstens eine wärmeaufnehmende Platte (31, 32) und eine Kühleinrichtung (53, 54), die mit der wärmeaufnehmenden Platte zu deren Kühlung verbunden ist, aufweist.

2. Vorrichtung gemäß Anspruch 1, wobei die Halbleiter-Schaltbauelemente (Q₁...Q₄) Bipolartransistoren, Isolierschicht-Bipolartransistoren oder MOS-Gate-gesteuerte Thyristoren sind.

3. Vorrichtung gemäß Anspruch 1 oder 2, wobei die Halbleiter-Schaltmodule in ein Paar (SM₁, SM₂) aus den ersten und zweiten Halbleiter-Schaltmodulen und ein Paar (SM₃, SM₄) aus den dritten und vierten Halbleiter-Schaltmodulen für die Wechselrichter-Hauptschaltung von jeder Phase aufgeteilt sind, und
die wärmeaufnehmenden Platten (31, 32) für jedes der Paare von Halbleiter-Schaltmodulen für die Wechselrichter-Hauptschaltung von jeder Phase getrennt vorgesehen sind.

4. Vorrichtung gemäß Anspruch 1 oder 2, wobei die wärmeaufnehmenden Platten (31, 32) zusammen an den zwei Paaren von Halbleiter-Schaltmodulen (SM₁, SM₂; SM₃, SM₄) und getrennt an der Wechselrichter-Hauptschaltung von jeder Phase angebracht sind.

5. Vorrichtung gemäß Anspruch 1 oder 2, wobei die Halbleiter-Schaltmodule in ein Paar (SM₁, SM₂) aus den ersten und zweiten Halbleiter-Schaltmodulen und ein Paar (SM₃, SM₄) aus den dritten und vierten Halbleiter-Schaltmodulen für die Wechselrichter-Hauptschaltung von jeder Phase aufgeteilt sind, und
die wärmeaufnehmenden Platten (31, 32) gemeinsam für die Paare von Halbleiter-Schaltmodulen vorgesehen sind.

6. Vorrichtung gemäß Anspruch 1 oder 2, wobei die Halbleiter-Schaltmodule in ein Paar (SM₁, SM₂) aus den ersten und zweiten Halbleiter-Schaltmodulen und ein Paar (SM₃, SM₄) aus den dritten und vierten Halbleiter-Schaltmodulen für die Wechselrichter-Hauptschaltung von jeder Phase aufgeteilt sind, und
die wärmeaufnehmenden Platten (31, 32) getrennt für jedes der Paare und gleichzeitig gemeinsam für die Wechselrichter-Hauptschaltung von jeder Phase angebracht sind.

7. Vorrichtung gemäß Anspruch 1 oder 2, wobei die wärmeaufnehmenden Platten (31, 32) gemeinsam für die zwei Paare und gemeinsam für die Wechselrichter-Hauptschaltung von jeder Phase vorgesehen sind.

8. Vorrichtung gemäß einem der Ansprüche 1 bis 7, wobei die Klemmdioden (DC₁, DC₂) an jeder wärmeaufnehmenden Platte (31, 32) angebracht sind.

9. Vorrichtung gemäß einem der Ansprüche 1 bis 8, wobei die wärmeaufnehmenden Platten (31, 32) abnehmbar in einer Öffnung an einer äußeren Wandung eines Gehäuses (36) angebracht sind, das die Komponenten des Wechselrichters hermetisch so einschließt, daß die Oberflächen der wärmeaufnehmenden Platten mit den Halbleiter-Schaltmodulen (SM₁...SM₄) sich an der Innenseite des Gehäuses befinden.

10. Vorrichtung gemäß Anspruch 9, wobei die ersten bis vierten Halbleiter-Schaltmodule (SM₁...SM₄), die an den wärmeaufnehmenden Platten (31, 32) angebracht sind, in der Reihenfolge ihrer Reihenschaltung angeordnet sind.

11. Vorrichtung gemäß einem der Ansprüche 1 bis 10, wobei die Kühleinrichtung (53, 54) aus Wärmeübertragungsröhren (51), die teilweise in den wärmeaufnehmenden Platten (31, 32) eingebettet sind, und wärmeabstrahlenden Rippen (52), die an freiliegenden Abschnitten der Wärmeübertragungsröhren angebracht sind, besteht.

12. Vorrichtung gemäß einem der Ansprüche 1 bis 10, wobei die Kühleinrichtung aus wärmeabstrahlenden Rippen (57), die zur Wärmeübertragung an den wärmeaufnehmenden Platten (31, 32) der Oberfläche mit den Halbleiter-Schaltmodulen (SM₁...SM₄) gegenüberliegend angeordnet sind.

13. Vorrichtung gemäß Anspruch 12, wobei die wärmeabstrahlenden Rippen (57) integral mit den wärmeaufnehmenden Platten (31, 32) ausgebildet sind.

## Revendications

1. Dispositif pour matériel roulant électrique du type dans lequel un circuit principal d'onduleur de chaque phase constituant un onduleur comprend: une paire de bornes (P, N) d'entrée de courant continu reliées à une source de courant continu; une borne (O) de point neutre reliée à un point neutre de ladite source de courant continu; un circuit série comprenant des premier à quatrième modules (SM₁...SM₄) de commutateurs à semiconducteur montés entre lesdites deux bornes d'entrée de courant continu; des diodes (DC₁, DC₂) de fixation de niveau montées entre un noeud desdites premier et deuxième modules de commutateurs à semiconducteur et ladite borne de point neutre et entre un noeud desdits troisième et quatrième modules de commutateurs à semiconducteur et ladite borne de point neutre; une borne (M) de sortie de courant alternatif reliée à un noeud desdits deuxième et troisième modules de commutateurs à semiconducteur, et un moyen (31, 32, 53, 54) de réception de chaleur relié auxdits premier à quatrième modules de commutateurs à semiconducteur; caractérisé en ce que
lesdits premier à quatrième modules (SM₁...SM₄) de commutateurs à semiconducteur sont constitués par des dispositifs de commutation (Q1...Q4) à semiconducteur aptes chacun à être excités à une fréquence supérieure à 500 Hz et étant disposés sur un substrat thermoconducteur (21) avec interposition d'un élément isolant (22),
lesdits premier à quatrième modules de commutateurs à semiconducteur sont groupés en deux paires de façon qu'une paire soit constituée par une combinaison d'un desdits premier et quatrième modules de commutateurs à semiconducteur et d'un desdits deuxième et troisième modules de commutateurs à semiconducteur et que l'autre paire soit constituée par celui desdits premier et quatrième modules de commutateurs à semiconducteur qui reste et par celui desdits deuxième et troisième modules de communtateurs à semiconducteur qui reste, chaque paire de modules de commutateurs à semiconducteur étant fixée au moyen de réception de chaleur et
ledit moyen de réception de chaleur comporte au moins une plaque (31, 32) de réception de chaleur et un moyen de refroidissement (53, 54) relié à ladite plaque de réception de chaleur pour refroidir ladite plaque de réception de chaleur.

2. Dispositif selon la revendication 1, dans lequel lesdits dispositifs de commutation (Q1...Q4) à semiconducteur sont des transistors bipolaires, des transistors bipolaires à grille isolée ou des thyristors MOS blocables par la gâchette.

3. Dispositif selon la revendication 1 ou 2, dans lequel lesdits modules de commutateurs à semiconducteur sont groupés en une paire (SM₁, SM₂) desdits premier et deuxième modules de commutateurs à semiconducteur et une paire (SM₃, SM₄) desdits troisième et quatrième modules de commutateurs à semiconducteur pour ledit circuit principal d'onduleur de chaque phase, et des plaques (31, 32) de réception de chaleur sont prévues séparément pour chacune desdites paires de modules de commutateurs à semiconducteur pour ledit circuit principal d'onduleur de chaque phase.

4. Dispositif selon la revendication 1 ou 2, dans lequel les plaques (31, 32) de réception de chaleur sont fixées en commun auxdites deux paires de modules (SM₁, SM₂; SM₃, SM₄) de commutateurs à semiconducteur et séparément audit circuit principal d'onduleur de chaque phase.

5. Dispositif selon la revendication 1 ou 2, dans lequel lesdits modules de commutateurs à semiconducteur sont groupés en une paire (SM₁, SM₂) desdits premier et deuxième modules de commutateurs à semiconducteur et une paire (SM₃, SM₄) desdits troisième et quatrième modules de commutateurs à semiconducteur pour ledit circuit principal d'onduleur de chaque phase, et
les plaques (31, 32) de réception de chaleur sont communes avec lesdites paires de modules de commutateurs à semiconducteur.

6. Dispositif selon la revendication 1 ou 2, dans lequel lesdits modules de commutateurs à semiconducteur sont groupés en une paire (SM₁, SM₂) desdits premier et deuxième modules de commutateurs à semiconducteur et une paire (SM₃, SM₄) desdits troisième et quatrième modules de commutateurs à semiconducteur pour ledit circuit principal d'onduleur de chaque phase, et
les plaques (31, 32) de réception de chaleur sont fixées séparément pour chacune desdites paires et, en même temps, en commun audit circuit principal d'onduleur de chaque phase.

7. Dispositif selon la revendication 1 ou 2, dans lequel les plaques (31, 32) de réception de chaleur sont en commun avec lesdites deux paires et en commun avec le circuit principal d'onduleur de chaque phase.

8. Dispositif selon l'une quelconque des revendications 1 à 7, dans lequel lesdites diodes (DC₁, DC₂) de fixation de niveau sont fixées aux plaques (31, 32) de réception de chaleur.

9. Dispositif selon l'une quelconque des revendications 1 à 8, dans lequel les plaques (31, 32) de réception de chaleur sont montées de manière amovible dans une ouverture d'une paroi extérieure d'un logement (36) contenant de manière hermétique les composants dudit onduleur de façon que les surfaces desdites plaques de réception de chaleur ayant lesdits modules (SM₁... SM₄) de commutateurs à semiconducteur se trouvent sur la face interne dudit logement.

10. Dispositif selon la revendication 9, dans lequel lesdits premier à quatrième modules (SM₁...SM₄) de commutateurs à semiconducteur fixés auxdites plaques (31, 32) de réception de chaleur sont disposés dans l'ordre de leur montage en série.

11. Dispositif selon l'une quelconque des revendications 1 à 10, dans lequel ledit moyen de réfroidissement (53, 54) est constitué par des caloducs (51) partiellement encastrés dans lesdites plaques (31, 32) de réception de chaleur et des ailettes (52) de rayonnement de chaleur fixées à des parties visibles desdits caloducs.

12. Dispositif selon l'une quelconque des revendications 1 à 10, dans lequel ledit moyen de refroidissement est constitué par des ailettes (57) de rayonnement de chaleur reliées, pour réaliser un transfert de chaleur, aux plaques (31, 32) de réception de chaleur orientées à l'opposé de la surface sur laquelle se trouvent lesdits modules (SM₁...SM₄) de commutateurs à semiconducteur.

13. Dispositif selon la revendication 12, dans lequel lesdites ailettes (57) de rayonnement de chaleur font corps avec lesdites plaques (31, 32) de réception de chaleur.
